# EUROPÄISCHE PATENTSCHRIFT

(11) **EP 1 892 576 B1**
(45) Veröffentlichungstag und Bekanntmachung des Hinweises auf die Patenterteilung: **12.06.2013**
(21) Anmeldenummer: 06405369.7
(22) Anmeldetag: 25.08.2006
(51) Int. Cl.: G03F 7/20, G03F 7/24, G03F 7/12

(54) **Belichtungsvorrichtung zur Herstellung von Siebdruckschablonen**
Exposure device for producing printing screen
Dispositif d'éclairage destiné à la fabrication d'écrans de sérigraphie

(43) Veröffentlichungstag der Anmeldung: 27.02.2008
(73) Patentinhaber: XPOSE Holding AG, 5014 Gretzenbach (CH)
(72) Erfinder: Berner, Peter, 5102 Rupperswil (CH)
(74) Vertreter: EGLI-EUROPEAN PATENT ATTORNEYS

(56) Entgegenhaltungen:
- EP-A1- 0 770 495
- EP-A1- 0 953 877
- WO-A-98/29782
- WO-A-02/093265
- WO-A-03/007082
- WO-A2-2006/007581
- US-A- 5 580 698
- US-A1- 2002 090 172
- US-A1- 2005 161 426

## Beschreibung

Die Erfindung betrifft eine Belichtungsvorrichtung zur Herstellung von Siebdruckschablonen nach Patentanspruch 1.

Die Erfindung betrifft insbesondere eine Belichtungsvorrichtung zur Herstellung von Siebdruckschablonen mit einer Halterung für die Siebdruckschablone, einem Belichtungssystem, das mindestens eine, einen Lichtstrahl erzeugende Lichtquelle und eine Optik in einem Belichtungskopf aufweist, ferner eine digitale Signale liefernde Signalquelle, welche mit dem Belichtungssystem in einer Weise in Verbindung steht, dass entsprechend den Signalen die ganze Siebdruckschablone belichtbar ist, und wobei der Belichtungskopf relativ zur Siebdruckschablone bewegbar ist. Es handelt sich somit um ein Vorrichtung zur Implementierung eines sogenannten CtS (Computer-to-Screen) Verfahrens, also um eine Vorrichtung, bei der die auf die Druckvorlagen (Siebdruckschablonen) zu übertragenden Informationen von den digitalen Signalen eines Computers gesteuert und über ein optisches Belichtungssystem bereitgestellt werden.

Aus der EP-0 953 877 ist ein Verfahren zur Herstellung von Siebdruckformen sowie eine Belichtungsvorrichtung hierfür bekannt, die die vorstehend genannten Merkmale aufweist. Bei dieser Vorrichtung weist das Belichtungssystem ein mikromechanisches Spiegelsystem auf, das mit einer Vielzahl von zumindest teilweise beweglichen Mikrospiegeln versehen ist. Derartige mikromechanische Spiegelsysteme sind auch bekannt als sogenannte DMDs (Digital Micromirror Devices) und sind im Handel erhältlich. Bei der vorliegenden Anwendung dient das mikromechanische Spiegelsystem dazu, einen Lichtstrahl so zu lenken und zu modulieren, dass die Stellung der beweglichen Mikrospiegel in Abhängigkeit von den Signalen eines Computers derart veränderbar ist, dass der jeweils gespiegelte Teil des Lichtstrahls entweder in den Lichtausgang geht oder nicht. Der Lichtausgang bedeutet hier natürlich das zur Siebdruckform bzw. Siebdruckschablone gelenkte Licht. Als Lichtquelle wird hier ein Dauerlicht verwendet, beispielsweise elektrodenlose, mikrowellenangeregte UV-Strahler. Zudem ist auch bei dieser Vorrichtung die Halterung mit der Siebdruckform und das Belichtungssystem relativ zueinander bewegbar.

Trotz des heute weit verbreiteten Einsatzes von DMD-Bausteinen (beispielsweise für Beamer) hat die Vorrichtung gemäss EP-0 953 877 jedoch einige gewichtige Nachteile. Da es sich bei den DMDs um mechanisch bewegte Spiegelsysteme handelt, bestehen natürlich gewisse Grenzen hinsichtlich sehr schnell zu erfolgender Wechsel in dem zu modulierenden Lichtstrahl. Gebräuchliche DMDs weisen eine Grenzfrequenz von ca. 20 kHz auf, was natürlich letztlich die ,Bebilderungsgeschwindigkeit' für die Siebdruckschablonen stark begrenzt. Insgesamt werden nach Angaben des Herstellers (CST) für einschlägige Geräte maximale Bebilderungsgeschwindigkeiten im Bereich von ca. 500 sq.ft/hr bei 65 lpi erreicht (allerdings nur bei "schnellen" Emulsionstypen und bei geringer Schablonendicke). Die erreichbare Bebilderungsgeschwindigkeit wird natürlich auch von der aufzuwendenden Strahlungsenergie bestimmt (je nach zu bebildernderndem Schablonen/Emulsions-Material werden zum Teil sehr unterschiedliche Strahlungsenergien benötigt). Auch hier sind der Anwendung von DMDs Grenzen gesetzt, weil durch die Anwendung von Spiegeln stets relativ hohe Verluste entstehen (die 'weggespiegelten' Anteile des Lichtstrahles manifestieren sich in der Form von relativ hoher Verlustwärme, die abgeführt werden muss). Schliesslich muss als Lichtquelle eine mit hoher Leistung arbeitende kontinuierliche Strahlungsquelle eingesetzt werden, was wiederum teuer ist und per se auch wieder mit relativ hoher Verlustleistung verbunden ist (weil nur ein Teil der zugeführten Energie überhaupt in nutzbare Strahlung umgesetzt wird). So werden, wiederum nach Angaben des Herstellers, UV-Lichtquellen mit Leistungen von üblicherweise 600 - 1200 Watt eingesetzt, die ihrerseits wieder eine spezielle Kühlung benötigen.

WO - 02093265 beschreibt ein Gerät zur Belichtung von Siebdruckschablonen bei das das Licht einer Anzahl von lichtemittieren den Dioden (LEDs) einzeln auf die zu belichtende Oberfläche projiziert wird.

Aufgabe der Erfindung ist es, eine verbesserte Belichtungsvorrichtung zur Herstellung von Siebdruckschablonen anzugeben.

Diese Aufgabe wird durch die Merkmale des Patentanspruchs 1 gelöst.

Erfindungsgemäss wird vorgeschlagen, als Lichtquelle eine Anzahl n gleichartiger, im Wellenlängenbereich von 300 - 450 nm arbeitender Laserdioden zu verwenden, die von den Signalen der Signalquelle (Computer) ansteuerbar sind, die Lichtsignale der Laserdioden über eine gleiche Anzahl n lichtleitender Fasern zu einer Rasterplatte im Belichtungskopf zu führen und den Lichtausgang der Rasterplatte zu einer im Wellenlängenbereich den Laserdioden angepassten Fokussieroptik im Belichtungskopf zu leiten.

Die Verwendung von direktmodulierbaren Laserdioden hat verschiedene signifikante Vorteile. Zum Einen entfällt die Notwendigkeit des kontinuierlichen Betriebes und somit kann die Verlustleistung der gesamten Belichtungsvorrichtung wesentlich gesenkt werden. Weiterhin sind der Reaktionsgeschwindigkeit von Laserdioden (zumindest in dem hier interessierenden Anwendungsbereich der Druckschablonenbelichtung) nach oben kaum Grenzen gesetzt, denn die erreichbaren Grenzfrequenzen liegen im GHz-Bereich. Weiterhin entfällt durch die einfache Ansteuerbarkeit der Laserdioden und die Abwesenheit von lichtablenkenden Spiegeln im Strahlengang eine weitere Ursache unerwünschter Verlustleistung, weil nämlich mit Ausnahme von Absorptionsverlusten in den Materialen im Strahlengang (Optikkomponenten) keine zusätzlichen Verluste in Kauf genommen werden müssen.

Da für die erfindungsgemässe Lösung eine Anzahl von Laserdioden verwendet werden muss und verwendbare Laserdioden zum Zweck der Bebilderung der gewünschten Substratmaterialien auch in einem Wellenlängenbereich von 300 - 450 nm arbeitenden müssen, wurden derartige Lösungen unter anderem auch aus Kostengründen bisher gar nicht in Betracht gezogen. Seit einiger Zeit sind nun aber leistungsfähige blaue Laserdioden, die im Wellenlängenbereich von 405 nm arbeiten (von Nichia) relativ kostengünstig erhältlich. Zudem ist mit dem vermehrten Aufkommen neuer DVD-Technologien, bei denen ebenfalls blaue Laserdioden eingesetzt werden, mit einem weiteren Preiszerfall für blaue Laserdioden zu rechnen, so dass die erfindungsgemässe Lösung gegenüber den DMD- und ähnlichen Lösungen zunehmend attraktiv wird. Im Übrigen muss noch darauf hingewiesen werden, dass bei DMD-Lösungen (also bei Mikrospiegel-Chips) stets ausgesuchte Chips verwendet werden müssen (da alle Pixel voll funktionstauglich sein müssen) und dass selbst in grossen Stückzahlen hergestellte DMD-Chips mit hoher Pixel-Zahl noch immer sehr teuer sind, was die erfindungsgemässe Lösung attraktiv erscheinen lässt, insbesondere dann, wenn - wie vorgesehen - die vorgeschlagene Belichtungseinrichtung in einer Weise ausgestaltet ist, dass die Anzahl der verwendeten Laserdioden erweiterbar ist. Softwaremässig, d.h. seitens der Signalquelle bzw. des Steuercomputers, ist eine solche Erweiterbarkeit (beispielsweise mit einer doppelten Anzahl von Laserdioden) hinsichtlich der Anpassbarkeit des einzusetzenden Steuerprogramms relativ einfach umzusetzen. Zudem gewinnt man mit dieser Massnahme den Vorteil, dass Geräte in verschiedenen Preis- und Leistungsklassen angeboten werden können.

Die erfindungsgemässe Belichtungsvorrichtung lässt sich zudem grundsätzlich sowohl für flache Siebdruckschablonenherstellung als auch für zylindrische Siebdruckschablonenherstellung einsetzen.

Eine Rasteranordnung einzeln ansteuerbarer Lichtquellen (in diesem Fall die Laserdioden) ist für Belichtungsvorrichtungen dieser Art jedoch von zentraler Bedeutung. Dabei müssen die Laserdioden selbst noch nicht notwendigerweise in der für die Belichtung des Schablonenmateriales notwendigen Rasteranordnung montiert sein. Vielmehr genügt es, die lichtleitenden Fasern zu einer Rasterplatte im Belichtungskopf zu führen und die Rasterplatte selbst so zu gestalten, dass die lichtleitenden Fasern dort in der für die Belichtung des Schablonenmateriales notwendigen Rasteranordnung erscheinen. Die Rasterplatte ist somit ein Faser-Array, das die lichtleitenden Fasern aufnimmt und diese in einer rechteckigen oder trapezartigen Rasteranordnung parallel zur optischen Achse der Fokussieroptik ausrichtet. Da vorgesehen ist, die lichtleitenden Fasern beidseits, also sowohl bei den Anschlüssen an die Laserdioden wie auch bei den Anschlüssen an die Rasterplatte, steckbar zu gestalten, ergeben sich Vorteile hinsichtlich der Flexibilität und Wartbarkeit.

Die Rasterplatte in der Rasteranordnung stellt somit eine Anzahl n von parallel zur optischen Achse der Fokussieroptik ausgerichtete Lichtstrahlen der Laserdioden bereit, wobei der Strahldurchmesser der einzelnen Lichtstrahlen im wesentlichen dem Durchmesser der lichtleitende Fasern entspricht und die Aufgabe der Fokussieroptik darin besteht, ein verkleinertes oder vergrössertes Abbild dieser Rasteranordnung auf dem zu bebildernden (belichtenden) Schablonenmaterial zu erzeugen. Um Unebenheiten des Schablonenmateriales im Betrieb ausgleichen zu können, ist die Fokussieroptik vorzugsweise auch mit einer Autofokussiereinrichtung ausgerüstet.

Die vorgeschlagene erfindungsgemässe Belichtungsvorrichtung lässt sich besonders gut bei einer in Portalbauweise aufgebauten Belichtungseinheit realisieren. Derartige Belichtungseinheiten sind wegen der Grösse der zu belichtenden Siebdruckschablonen platzsparend oft vertikal angeordnet, d.h. die Halterung für die Siebdruckschablone liegt in einer vertikalen Ebene. Die Belichtungseinheit bildet dabei zusammen mit einer Steuereinheit und einer Rechnereinheit die Belichtungsvorrichtung zur Herstellung von Siebdruckschablonen. Vorteilhafterweise sind dabei die Laserdioden und die lichtleitenden Fasern in wärmeableitenden Modulen in einem Interfaceteil einsteckbar angeordnet.

Das Interfaceteil ist dabei mit den Modulen in einer Weise an der Belichtungseinheit angeordnet, dass es die Bewegungen des Belichtungskopfes nur in einer der zur Belichtung eines Schablonenmateriales erforderlichen Bewegungsrichtungen mitmacht, um die für einen Belichtungsvorgang zu bewegende Masse möglichst klein zu halten. Dies ist beispielsweise der Fall, wenn das Interfaceteil mit den Modulen auf dem Portalarm eines in Portalbauweise aufgebauten Belichtungstisches angeordnet ist. Das Interfaceteil macht dann die relativ langsamen Bewegungen des Belichtungskopf in X-Richtung (Bewegungsrichtung des Portalarms) mit, die relativ schnellen Bewegungen des Belichtungskopf in Y-Richtung (Bewegungsrichtung des Belichtungskopfes auf dem Portalarm) jedoch nicht. Alternativ wäre es auch möglich, das Interfaceteil mit den Modulen an der Belichtungseinheit fix anzubringen. Das Interfaceteil mit den Modulen würde dann gar keine der Bewegungen des Belichtungskopfes in den zur Belichtung eines Schablonenmateriales erforderlichen Bewegungsrichtungen mitmachen.

Ein weiterer Vorteil der erfindungsgemässen Belichtungsvorrichtung liegt zweifellos auch darin, dass durch die Möglichkeit der Verwendung einer im Wellenlängenbereich den Laserdioden angepassten Fokussieroptik im Belichtungskopf preisgünstigere Optiken eingesetzt werden können. Wird nämlich mit Lichtquellen mit einer breiteren spektralen Verteilung als bei Laserdioden gearbeitet, muss wegen der erforderlichen Fokussiergenauigkeit auch die Optik für den ganzen abzudeckenden Spektralbereich optimiert sein. Da bei der erfindungsgemässen Belichtungsvorrichtung auch vorgesehen ist, die Belichtungsoptiken austauschbar oder mit geringem Aufwand umschaltbar zu gestalten, kann die Vorrichtung sehr leicht auf die Bearbeitung von Schablonenmaterial mit unterschiedlichen Anforderungen bezüglich spektraler Empfindlichkeit umgestellt werden.

Das neue Maschinenkonzept hat deshalb insbesondere bezüglich Umstellbarkeit, Wartbarkeit und Erweiterbarkeit ganz beträchtliche Vorteile gegenüber den gängigen Maschinenkonzepten.

Im Folgenden wird die Erfindung anhand eines Ausführungsbeispieles näher erläutert.

Dabei zeigt die einzige Figur:

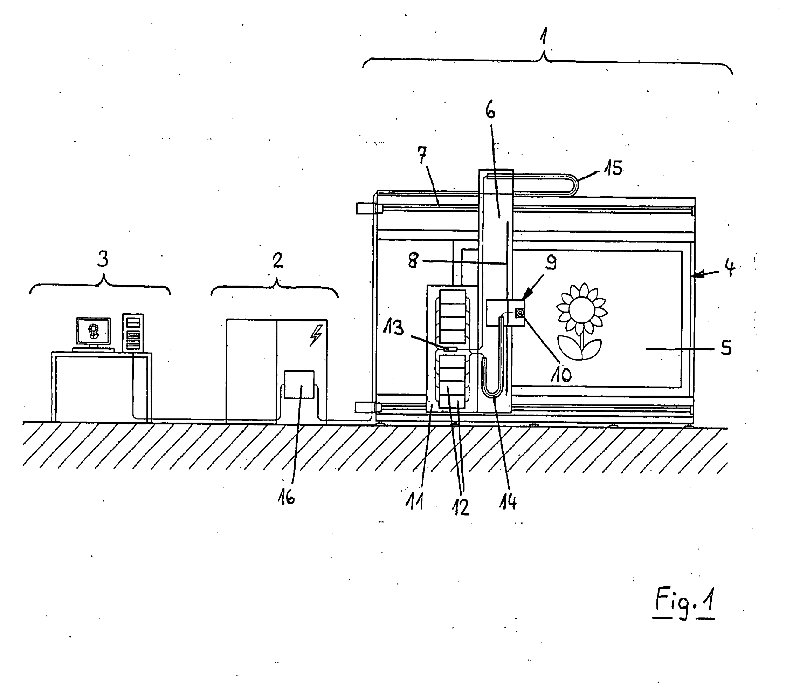

- Fig. 1: eine Belichtungsvorrichtung zur Herstellung von Siebdruckschablonen in Portalbauweise.

Eine Belichtungsvorrichtung zur Herstellung von Siebdruckschablonen ist in Portalbauweise ausgeführt und besteht im wesentlichen aus einer Belichtungseinheit 1, einer Steuereinheit 2 und einer Rechnereinheit 3.

Die Belichtungseinheit 1 umfasst dabei einen vertikal angeordneten Bearbeitungstisch mit einer Halterung 4 für (zu belichtende) Siebdruckschablonen 5. Über der Halterung 4 und der Siebdruckschablone ist ein Portalarm 6 auf einer X-Achsenführung 7 in einer X-Richtung bewegbar. Auf dem Portalarm 6 ist auf einer Y-Achsenführung 8 ein Belichtungskopf 9 mit einer Fokussieroptik 10 in einer Y-Richtung bewegbar. Die X-Richtung entspricht somit der Bewegungsrichtung des Portalarms 6. Sowohl für die Bewegung in X-Richtung als auch für die Bewegung in Y-Richtung sind Präzisionsführungen und Präzisionsantriebe vorhanden (nicht dargestellt).

Am Portalarm 6 ist ein Interfaceteil 11 angebracht. Auf dem Interfaceteil 11 befinden sich mehrere wärmeableitende Module 12 mit Gruppen von Laserdioden sowie ein Datenverteiler 13 und Schnittstellen-Elektronikkomponenten (nicht dargestellt). Im Interfaceteil werden die von der Rechnereinheit 3 als Signalquelle stammenden digitalen Signale in optische Signale umgewandelt. Da der Belichtungskopf 9 gegenüber den Modulen 12 mit den Laserdioden beweglich angeordnet ist, werden die Signale von den Laserdioden über lichtleitende Fasern über eine Y-Schleppkette 14 zum Belichtungskopf 9 übertragen.

Beispielsweise können so auf dem Interfaceteil 4 bis 8 Module 12 mit Gruppen von je 16 Laserdioden angeordnet sein. Dies ergibt dann insgesamt eine Anzahl n von 64 bis 128 Laserdioden, wobei der Lichtausgang jeder Laserdiode über je eine separate lichtleitende Faser über die Y-Schleppkette 14 zur Rasterplatte im Belichtungskopf 9 geleitet wird. Die Laserdioden arbeiten dabei in einem Wellenlängenbereich von 300 - 450 nm, vorzugsweise im Blaulichtbereich bei 405 nm. Die Laserdioden werden in einem direktmodulierten Betrieb verwendet, d.h. sie werden in der üblichen Art direkt von einem digitalen Signal angesteuert.

Da auch der Portalarm 6 mit dem Interfaceteil 11 gegenüber dem Bearbeitungstisch bzw. der Halterung 4 beweglich angeordnet ist, werden die Signale zum Datenverteiler 13 über eine X-Schleppkette 15 übertragen. Im Gegensatz zur Y-Schleppkette 14 werden hier aber auch noch die erforderlichen Signale und Stromzuführungen für die Steuerung und Bewegung des Belichtungskopfes 9 in Y-Richtung mitgeführt.

Bei Geräten dieser Art wird eine von der Halterung 4 aufgenommene Siebdruckschablone 5 durch Bewegungen des Belichtungskopfes in X- und Y-Richtung vollständig oder teilweise belichtet. Dabei kann davon ausgegangen werden, dass die Bewegung in X-Richtung in der Regel langsamer erfolgt als die Bewegung in Y-Richtung, weil in Y-Richtung nur eine sehr viel kleinere Masse bewegt werden muss.

Die Funktion der Steuereinheit 2 besteht grundsätzlich darin, die Bewegungen des Belichtungskopfes 9 in X- und Y-Richtung zu steuern. Die dazu notwendigen Funktionen sind vorteilhafterweise in einer speicherprogrammierbaren Steuerung 16 (SPS-Einheit) realisiert. Die Steuereinheit 2 enthält auch die zur Bewegungssteuerung notwendigen Treiberschaltungen etc.

Von der Rechnereinheit 3 (Signalquelle) schliesslich werden die auf eine Siebdruckschablone 5 zu belichtenden Daten bereitgestellt und der Belichtungsvorgang gesteuert. Sowohl die Funktionen der Rechnereinheit 3 wie auch die Funktionen der Steuereinheit 2 sind aus gattungsgemässen Geräten dem Fachmann wohlbekannt und bedürfen deshalb hier keiner weiteren Erläuterung.

Im neuen Maschinenkonzept gemäss obiger Beschreibung ist auch vorgesehen, mit diversen Einzelmassnahmen eine möglichst grosse Flexibilität zu erreichen, so z.B. mit:
- konsequenter Realisierung des Modulkonzeptes für die Laserdioden, wobei jeweils pro Modul 12 im Interfaceteil 11 eine fixe Anzahl von Laserdioden eines gewünschten Typs vorhanden ist. Durch den Einbau zusätzlicher Module kann so die Bebilderungsgeschwindigkeit der Belichtungsvorrichtung auf einfache Weise erhöht werden (Ausbaubarkeit/Leistungssteigerung).
- beidseitig steckbaren lichtleitenden Fasern zwischen den Modulen 12 und der Rasterplatte im Belichtungskopf 9. Diese erleichtert nicht nur die Wartbarkeit des Systems sondern erleichtert auch die Ausbaubarkeit.
- mit der Austauschbarkeit der Fokussieroptik 10 im Belichtungskopf 9. Indem zusammen mit den gewünschten Laserdioden Fokussieroptiken verwendet werden, die auf den Wellenlängenbereich der verwendeten Laserdioden abgestimmt sind, können auch sehr unterschiedliche Materialen für die Siebdruckschablonen bearbeitet werden.

Insgesamt erhält man mit der erfindungsgemässen Belichtungsvorrichtung zur Herstellung von Siebdruckschablonen ein preisgünstiges, leistungsfähiges und ausbaubares System, mit dem grundsätzlich alle gängigen Materialien für Siebdruckschablonen bearbeitet werden können.

## Patentansprüche

1. Belichtungsvorrichtung zur Herstellung von Siebdruckschablonen (5), mit einer Halterung (4) für die Siebdruckschablone (5), einem Belichtungssystem, das mindestens eine, einen Lichtstrahl erzeugende Lichtquelle und eine Optik in einem Belichtungskopf (9) aufweist, ferner mit einer digitale Signale liefernden Signalquelle, welche mit dem Belichtungssystem in einer Weise in Verbindung steht, dass entsprechend den Signalen die ganze Siebdruckschablone (5) belichtbar ist, wobei der Belichtungskopf (9) relativ zur Siebdruckschablone (5) bewegbar ist, **dadurch gekennzeichnet, dass** die Lichtquelle eine Anzahl n gleichartiger, im Wellenlängenbereich von 300 - 450 nm arbeitender Laserdioden aufweist, die von den Signalen der Signalquelle ansteuerbar sind,
die Lichtsignale der Laserdioden über eine gleiche Anzahl n lichtleitender Fasern zu einer Rasterplatte im Belichtungskopf (9) geführt sind und der Lichtausgang der Rasterplatte zu einer im Wellenlängenbereich den Laserdioden angepassten Fokussieroptik (10) im Belichtungskopf (9) geleitet wird,
Anschlüsse der lichtleitenden Fasern an die Laserdioden und/oder an die Rasterplatte steckbar gestaltet sind,
die Laserdioden als direktmodulierte Laserdioden ausgebildet sind,
die Rasterplatte ein Faser-Array ist, das die lichtleitenden Fasern aufnimmt und diese in einer rechteckigen oder trapezartigen Rasteranordnung parallel zur optischen Achse der Fokussieroptik (10) ausrichtet, und
die Rasterplatte in der Rasteranordnung eine Anzahl n von parallel zur optischen Achse der Fokussieroptik (10) ausgerichtete Lichtstrahlen der Laserdioden bereitstellt, wobei der Strahldurchmesser der einzelnen Lichtstrahlen im wesentlichen dem Durchmesser der lichtleitenden Fasern entspricht.

2. Belichtungsvorrichtung nach Patentanspruch 1, **dadurch gekennzeichnet, dass** die Belichtungsvorrichtung sowohl für flache Siebdruckschablonenherstellung als auch für zylindrische Siebdruckschablonenherstellung einsetzbar ist.

3. Belichtungsvorrichtung nach Patentanspruch 1 oder 2, **dadurch gekennzeichnet, dass** die Laserdioden in einem gepulsten Energiebereich von > 30 mW, vorzugsweise >= 200 mW arbeiten, um alle handelsüblichen Schablonenmaterialien bebildern zu können.

4. Belichtungsvorrichtung nach einem der Patentansprüche 1 bis 3, **dadurch gekennzeichnet, dass** die Laserdioden im Blaulichtbereich bei 405 nm arbeiten.

5. Belichtungsvorrichtung nach einem der Patentansprüche 1 bis 4, **dadurch gekennzeichnet, dass** das Belichtungssystem in der Anzahl n der verwendeten Laserdioden erweiterbar ist.

6. Belichtungsvorrichtung nach einem der Patentansprüche 1 bis 5, **dadurch gekennzeichnet, dass** die Laserdioden und die lichtleitenden Fasern in wärmeableitenden Modulen (12) in einem Interfaceteil (11) einsteckbar angeordnet sind.

7. Belichtungsvorrichtung nach Patentanspruch 6, **dadurch gekennzeichnet, dass** das Interfaceteil (11) mit den Modulen (12) in einer Weise angeordnet ist, dass es die Bewegungen des Belichtungskopfes (9) nicht oder nur in einer der zur Belichtung eines Schablonenmateriales erforderlichen Bewegungsrichtungen mitmacht, um die für einen Belichtungsvorgang zu bewegende Masse möglichst klein zu halten.

8. Belichtungsvorrichtung nach Patentanspruch 7, **dadurch gekennzeichnet, dass** das Interfaceteil (11) mit den Modulen (12) auf einem Portalarm (6) einer in Portalbauweise aufgebauten Belichtungseinheit angeordnet ist.

9. Belichtungsvorrichtung nach einem der Patentansprüche 1 bis 8, **dadurch gekennzeichnet, dass** die Fokussieroptik (10) ein verkleinertes oder vergrössertes Abbild der Rasteranordnung auf dem zu bebildernden Schablonenmaterial bereitstellt.

10. Belichtungsvorrichtung nach Patentanspruch 9, **dadurch gekennzeichnet, dass** die Fokussieroptik (10) eine Autofokuseinrichtung aufweist.

## Claims

1. An exposure device for producing printing screens (5), having a holder (4) for the printing screens (5), an exposure system which has at least one light source for producing a beam of light and a lens in an exposure head (9), additionally having a signal source supplying digital signals which is connected to the exposure system in such a manner that the whole printing screen (5) can be exposed in accordance with the signals, wherein the exposure head (9) can be moved relative to the printing screen (5),
**characterized in that**
the light source has a number n of identical laser diodes operating in the wavelength range of 300 - 450 nm, which can be driven by the signals from the signal source,
the light signals of the laser diodes are guided to a raster plate in the exposure head (9) by using an equal number n of light-guiding fibres and the raster plate is guided to a focussing lens (10) in the exposure head (9) that is matched to the laser diodes in terms of its wavelength range,
connectors from the light-guiding fibres are designed such that they can be plugged onto the laser diodes and/or to the raster plate,
the laser diodes are direct-modulated laser diodes,
the raster plate is a fibre array, which receives the light-guiding fibres and aligns them in a rectangular or trapezoidal raster arrangement parallel to the optical axis of the focussing lens (10), and
the raster plate in the raster arrangement provides a number n of light beams of the laser diodes which are aligned parallel to the optical axis of the focussing lens (10), wherein the beam diameter of the individual light beams essentially corresponds to the diameter of the light-guiding fibres.

2. The exposure device according to Claim 1,
**characterized in that**
the exposure device can be used for producing both flat printing screens and cylindrical printing screens.

3. The exposure device according to Claim 1 or 2,
**characterized in that**
the laser diodes operate in pulsed energy range of >30mW, preferably >=200mW, in order to be able to apply images to all commercially available screen printing materials.

4. The exposure device according to any one of Claims 1 to 3,
**characterized in that**
the laser diodes operate in the blue light region at 405nm.

5. The exposure device according to any one of Claims 1 to 4,
**characterized in that**
the exposure device can be extended in the number n of laser diodes that are used.

6. The exposure device according to any one of Claims 1 to 5,
**characterized in that**
the laser diodes and the light-guiding fibres are arranged so that they can be inserted in heat dissipating modules (12) in an interface part (11).

7. The exposure device according to Claim 6,
**characterized in that**
the interface part (11) with the modules (12) is arranged in such a manner that it either does not take part in the movements of the exposure head (9), or only takes part in one of the directions of movement required to expose a screen printing material, in order to keep as small as possible the mass that needs to be moved for an exposure process.

8. The exposure device according to Claim 7,
**characterized in that**
the interface part (11) with the modules (12) is arranged on a portal arm (6) of an exposure unit which is assembled according to a portal design.

9. The exposure device according to any one of Claims 1 to 8,
**characterized in that**
the focussing lens (10) provides a reduced or magnified image of the raster arrangement on the screen printing material which is to be illustrated.

10. The exposure device according to Claim 9,
**characterized in that**
the focussing lens (10) has an auto-focussing device.

## Revendications

1. Dispositif d'exposition pour la fabrication de pochoirs de sérigraphie (5), avec un support (4) pour le pochoir de sérigraphe (5), un système d'exposition qui présente au moins une source de lumière générant un rayon lumineux et une unité optique dans une tête d'exposition (9), avec en outre une source de signaux délivrant des signaux numériques, laquelle est en liaison avec le système d'exposition de telle manière que la totalité du pochoir de sérigraphie (5) peut être exposée en fonction des signaux, la tête d'exposition (9) pouvant être déplacée par rapport au pochoir de sérigraphie (5), **caractérisé en ce que** la source de lumière présente un nombre n de diodes laser du même type travaillant dans la plage des longueurs d'onde de 300-450 nm, lesquelles peuvent être commandées par les signaux de la source de signaux,
**en ce que** les signaux lumineux des diodes laser sont guidés par l'intermédiaire d'un nombre n identique de fibres optiques vers une plaque de trame dans la tête d'exposition (9) et **en ce que** la sortie de lumière de la plaque de trame est dirigée vers une unité optique de focalisation (10) - adaptée aux diodes laser dans la plage de longueurs d'onde - dans la tête d'exposition (9),
des raccordements des fibres optiques étant configurés de manière enfichable sur les diodes laser et/ou la plaque de trame,
les diodes laser étant réalisées en tant que diodes laser modulées directement,
la plaque de trame étant un réseau de fibres qui accueille les fibres optiques et oriente celles-ci selon un agencement de trame rectangulaire ou trapézoïdal parallèlement à l'axe optique de l'unité optique de focalisation (10), et
la plaque de trame dans l'agencement de trame mettant à disposition un nombre n de rayons optiques des diodes laser qui sont orientés parallèlement à l'axe optique de l'unité optique de focalisation (10), le diamètre de rayon des rayons lumineux individuels correspondant pour l'essentiel au diamètre des fibres optiques.

2. Dispositif d'exposition selon la revendication 1, **caractérisé en ce que** le dispositif d'exposition peut être utilisé pour la fabrication de pochoirs de sérigraphie plats, tout comme également la fabrication de pochoirs de sérigraphie cylindriques.

3. Dispositif d'exposition selon la revendication 1 ou 2, **caractérisé en ce que** les diodes laser travaillent dans une plage d'énergie pulsée > 30 mW, de préférence ≥ 200 mW, afin de pouvoir imager tous les matériaux de pochoirs disponibles dans le commerce.

4. Dispositif d'exposition selon l'une des revendications 1 à 3, **caractérisé en ce que** les diodes laser travaillent dans la plage de lumière bleue avec 405 nm.

5. Dispositif d'exposition selon l'une des revendications 1 à 4, **caractérisé en ce que** le système d'exposition peut être agrandi du nombre n des diodes laser utilisées.

6. Dispositif d'exposition selon l'une des revendications 1 à 5, **caractérisé en ce que** les diodes laser et les fibres optiques sont disposées de manière enfichable dans des modules à dissipation de chaleur (12) dans une partie d'interface (11).

7. Dispositif d'exposition selon la revendication 6, **caractérisé en ce que** la partie d'interface (11) avec les modules (12) est disposée d'une manière à ne pas suivre les déplacements de la tête d'exposition (9) ou bien à seulement suivre l'une des directions de déplacement nécessaires pour l'exposition d'un matériau de pochoir, afin de garder la masse à déplacer aussi petite que possible pour un processus d'exposition.

8. Dispositif d'exposition selon la revendication 7, **caractérisé en ce que** la partie d'interface (11) avec les modules (12) est disposée sur un bras de potence (6) d'une unité d'exposition configurée selon une configuration en potence.

9. Dispositif d'exposition selon l'une des revendications 1 à 8, **caractérisé en ce que** l'unité optique de focalisation (10) met à disposition une image réduite ou agrandie de l'agencement de trame sur le matériau de pochoir à imager.

10. Dispositif d'exposition selon la revendication 9, **caractérisé en ce que** l'unité optique de focalisation (10) présente un dispositif de focalisation automatique.
